# EUROPEAN PATENT APPLICATION

(11) **EP 4 614 543 A1**
(43) Date of publication of application: **10.09.2025**
(21) Application number: 24881076.4
(22) Date of filing: 28.06.2024
(51) Int. Cl.: H01H 31/02, H02M 1/00

(54) **ROTARY ISOLATION SWITCH AND POWER CONVERTER**

(30) Priority: 24.10.2023 CN 202322863929 U
(71) Applicant: Huawei Digital Power Technologies Co., Ltd., Shenzhen, Guangdong 518043 (CN)
(72) Inventor: SUN, Jisheng, Shenzhen, Guangdong 518043 (CN); WANG, Keying, Shenzhen, Guangdong 518043 (CN); WANG, Zaixing, Shenzhen, Guangdong 518043 (CN)
(74) Representative: Maiwald GmbH
(86) International application number: PCT/CN2024/102594
(87) International publication number: WO 2025/086701

(57) **Abstract**

This application provides a rotary isolator switch and a power converter. The rotary isolator switch includes a plurality of switch units and a drive mechanism that are sequentially arranged in a first direction. Each switch unit includes a moving contact component. The drive mechanism drives the moving contact component to rotate. A moving contact component that is adjacent to the drive mechanism is a first moving contact component. The drive mechanism is connected to the first moving contact component and is configured to apply rotation force to the first moving contact component. Two adjacent moving contact components are connected through insertion. A switch unit that is farthest away from the drive mechanism is a second switch unit. The second switch unit includes an isolation cover plate. The isolation cover plate includes an observation hole and a reference mark, so that a rotation angle of a second moving contact component can be visualized, and a connection status of the rotary isolator switch can be determined based on a position of the second moving contact component. The reference mark is located on a peripheral side of the observation hole. A pointer is disposed on a side that is of the second moving contact component and that faces the isolation cover plate. The second moving contact component rotates based on a manner in which the pointer is aligned with the reference mark.

## Description

### CROSS-REFERENCE TO RELATED APPLICATIONS

This application claims priority to Chinese Patent Application No. 202322863929.4, filed with the China National Intellectual Property Administration on October 24, 2023 and entitled "ROTARY ISOLATOR SWITCH AND POWER CONVERTER", which is incorporated herein by reference in its entirety.

### TECHNICAL FIELD

This application relates to the field of switch device technologies, and in particular, to a rotary isolator switch and a power converter.

### BACKGROUND

In a photovoltaic system, a rotary isolator switch is usually used to separately isolate, protect, and disconnect a photovoltaic panel. The rotary isolator switch is usually formed by stacking contact components. Each contact component includes a housing, a moving contact, and a fixed contact that matches the moving contact. The moving contact is connected to or disconnected from the fixed contact through rotation. Moving contacts in two adjacent layers of contact components rotate synchronously. Cooperation of the moving contacts and connection mechanisms at the two adjacent layers is needed to further ensure synchronous rotation of moving and fixed contacts in a plurality of layers of housings. The connection mechanisms at the two adjacent layers are usually connected in an insertion manner. Therefore, under impact of a processing tolerance of a connector and an assembly clearance, a rotation angle of each fixed contact has a deviation. Under impact of the deviation, it cannot be ensured that the moving contact at each layer is in full contact with the fixed contact that matches the moving contact. Moreover, as a quantity of contact component layers increases, the deviation increases, causing poor contact of the rotary isolator switch.

### SUMMARY

This application provides a rotary isolator switch and a power converter. An internal operation of the rotary isolator switch is visualized, reducing poor contact of the rotary isolator switch.

According to a first aspect, this application provides a rotary isolator switch. The rotary isolator switch includes a drive mechanism and a plurality of switch units. The drive mechanism and the plurality of switch units are sequentially arranged and installed along a first direction. Each switch unit includes a moving contact component. A moving contact component that is adjacent to the drive mechanism is a first moving contact component. The drive mechanism is connected to the first moving contact component and is configured to apply rotation force to the first moving contact component. Two adjacent moving contact components are connected through insertion and are configured to sequentially transfer the rotation force, so that the drive mechanism drives the moving contact components in the plurality of switch units to separately rotate around an axis. A direction of the axis is the same as the first direction. A switch unit that is farthest away from the drive mechanism is a second switch unit. A moving contact component in the second switch unit is a second moving contact component. The second switch unit further includes an isolation cover plate. The isolation cover plate is located on a side that is of the second moving contact component and that is away from the drive mechanism. The isolation cover plate includes an observation hole and a reference mark. The reference mark is located on a peripheral side of the observation hole. Vertical projections of the observation hole and the second moving contact component in the first direction partially overlap. A pointer is disposed on a side that is of the second moving contact component and that faces the isolation cover plate. The second moving contact component rotates around the axis based on a manner in which the pointer is aligned with the reference mark. The observation hole is used for observation of an operation inside the rotary isolator switch from the outside of the rotary isolator switch. The observation hole and the reference mark are provided on the isolation cover plate, so that a rotation angle of the second moving contact component can be visualized. In this way, effect of observing a position of the second contact component in real time is achieved, and a connection status of the rotary isolator switch can be further determined based on the position of the second contact component, thereby reducing a case in which the rotary isolator switch is in poor contact.

In a technical solution, the second moving contact component includes a connection mechanism and a moving contact. The connection mechanism includes a first housing and a second housing. The first housing and the second housing are connected in a snap-fit manner to form an accommodating cavity. The moving contact is fastened to the accommodating cavity. The moving contact is fastened to the connection mechanism, and can rotate around the axis with the connection mechanism. The connection mechanism, as a transmission component, applies the rotation force of the drive mechanism to a fixed contact, to reliably transfer the rotation force.

In a technical solution, the second housing is located between the first housing and the isolation cover plate, and the pointer is disposed on a surface of a side that is of the second housing and that faces the isolation cover plate. The pointer is perpendicular to the axis, and an extension line of the pointer passes through the axis. The pointer can rotate with the second housing of the connection mechanism, to show a real-time position of the second moving contact component. A rotation status of the moving contact in the second moving contact component is obtained by observing a position relationship between the pointer and the reference mark.

In a technical solution, the switch unit further includes a fixed contact. The fixed contact is installed on a peripheral side of the moving contact component. The moving contact component includes the moving contact. When the drive mechanism drives the moving contact component to rotate, the moving contact in the moving contact component and the fixed contact are in contact with each other or are separated from each other, thereby implementing connection or disconnection of the switch unit.

In a technical solution, the fixed contact includes a first surface, and the moving contact includes a contact part. When the contact part and the first surface are in contact with each other, the switch unit is in a connected state. The contact part can slide on the first surface in a rotation process, and a sliding range is large, so that the moving contact still has some adjustment space when remaining in a connected state. This improves reliability of contact between the moving contact and the fixed contact.

In a technical solution, the reference mark is an annular sector, and a center of the annular sector is located on the axis. When the contact part of the second moving contact component is in contact with the first surface, a vertical projection of the pointer in the first direction points to the annular sector. The annular sector is used as a reference mark, so that whether the pointer is in an area range in which the switch unit is connected can be intuitively displayed.

In a technical solution, a central angle of the annular sector is α. After a plurality of experimental tests, when α = 7°, the pointer points to an area of the annular sector, and all switch units are in a connected state.

In a technical solution, the observation hole and the moving contact component are coaxially disposed, or the observation hole is located on a peripheral side of a center of the moving contact component. The observation hole is located at the foregoing position, so that an operation inside the rotary isolator switch can be clearly observed.

In a technical solution, the rotary isolator switch further includes a spacer that covers the observation hole, and the spacer is made of a transparent insulation material. The spacer seals the isolation cover plate, thereby improving insulation performance of the isolation cover plate.

In a technical solution, when the rotary isolator switch needs to be connected to 14 photovoltaic panel strings, a quantity of switch units is 12, so that good power generation effect can be achieved.

According to another aspect, this application further provides a power converter. The power converter includes the rotary isolator switch, a power conversion circuit, and a housing. The rotary isolator switch is fastened to the housing. The power conversion circuit is located in the housing. The rotary isolator switch is configured to connect to a direct current source and the power conversion circuit. The direct current source supplies power to the power converter when the rotary isolator switch is turned on. The direct current source stops supplying power to the power converter when the rotary isolator switch is turned off. Because operation of internal components of the foregoing rotary isolator switch is visualized, a case of poor contact is reduced, so that the power converter runs reliably.

### BRIEF DESCRIPTION OF DRAWINGS

FIG. 1 is a diagram of networking of a photovoltaic power generation system;
FIG. 2 is a diagram of a structure of a rotary isolator switch according to an embodiment of this application;
FIG. 3 is a top view of a structure of a rotary isolator switch according to an embodiment of this application;
FIG. 4 is a diagram of a structure of a switch unit according to an embodiment of this application;
FIG. 5 is a partial diagram of a moving contact component and a fixed contact according to an embodiment of this application;
FIG. 6 is a front view of a rotary isolator switch according to an embodiment of this application;
FIG. 7 is a diagram of an isolation cover plate according to an embodiment of this application;
FIG. 8 is a diagram of a structure of a rotary isolator switch from another angle according to an embodiment of this application;
FIG. 9 is a diagram of a structure of insertion and a connection between a first housing and a second housing of two adjacent connection mechanisms according to an embodiment of this application; and
FIG. 10 is a diagram of a structure of a power converter according to an embodiment of this application.

### Reference numerals:

1: drive mechanism; 2: switch unit; 3: isolation cover plate; 4: moving contact component; 21: first switch unit; 41: first moving contact component; 22: second switch unit; 42: second moving contact component; 43: moving contact; 23: switch housing; 24: fixed contact; 241: first surface; 431: contact part; 5: observation hole; 6: reference mark; 7: pointer; 8: spacer; 11: operation member; 12: core shaft; 44: connection mechanism; 441: first housing; 442: second housing; 4411: second surface; 4421: third surface; 45: slot; 46: pin; 100: rotary isolator switch; 200: power conversion circuit; 300: housing; 400: direct current source.

### DESCRIPTION OF EMBODIMENTS

To make the objectives, technical solutions, and advantages of this application clearer, the following further describes this application in detail with reference to the accompanying drawings. However, example implementations may be implemented in a plurality of forms, and should not be construed as being limited to implementations described herein. Identical reference numerals in the accompanying drawings denote identical or similar structures. Therefore, repeated description thereof is omitted. Expressions of positions and directions in embodiments of this application are described by using the accompanying drawings as an example. However, changes may also be made as required, and all the changes fall within the protection scope of this application. The accompanying drawings in embodiments of this application are merely used to illustrate relative position relationships and do not represent an actual scale.

It should be noted that specific details are set forth in the following description to facilitate understanding of this application. However, this application can be implemented in a plurality of manners different from those described herein, and a person skilled in the art can perform similar generalization without departing from the connotation of this application. Therefore, this application is not limited to the specific implementations disclosed below.

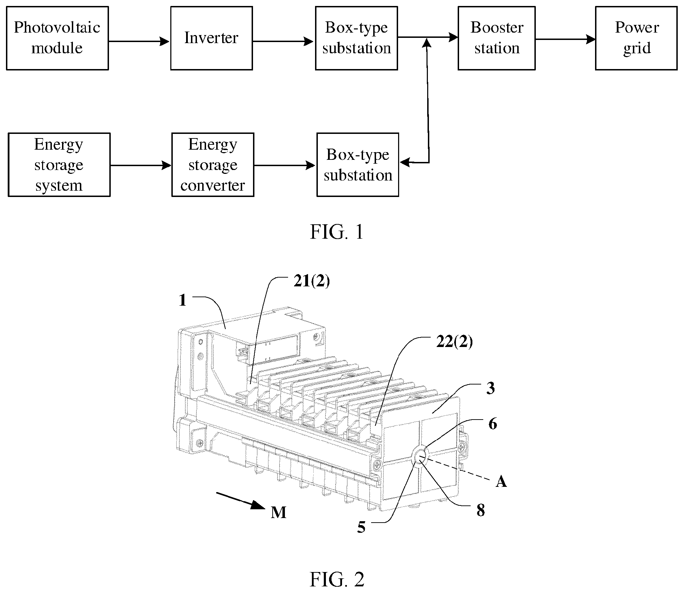

To facilitate understanding of a rotary isolator switch provided in embodiments of this application, the following first describes an application scenario of the rotary isolator switch. A photovoltaic power generation system is a system that generates power by using solar energy. The photovoltaic power generation system converts solar energy into electric energy to provide people with clean and renewable energy. FIG. 1 is a diagram of networking of a photovoltaic power generation system. As shown in FIG. 1, the photovoltaic power generation system includes an energy storage system and a photovoltaic module. A photovoltaic panel string in the photovoltaic module converts solar energy into a direct current by using photovoltaic effect. An inverter converts the direct current output by the photovoltaic module into an alternating current and further transfers the alternating current to a box-type substation. The box-type substation converts a low-voltage alternating current output by the inverter into a medium-voltage alternating current, and then transfers the alternating current to a booster station, a power grid, or a box-type substation corresponding to the energy storage system. The energy storage system is configured to store unstable electric energy from the photovoltaic module. The energy storage system includes a plurality of battery clusters that are connected in parallel. The battery cluster outputs stable electric energy to the power grid by using an energy storage converter and a corresponding box-type substation.

A rotary isolator switch is usually connected to the battery cluster or the photovoltaic panel string. When the battery cluster or the photovoltaic panel string needs to be maintained, repaired, or replaced, the isolator switch needs to be turned off to disconnect a circuit. In this way, it can be ensured that no danger is caused to personnel and devices during maintenance and repair of the photovoltaic power generation system. The isolator switch can be further configured to adjust and control the photovoltaic power generation system.

The rotary isolator switch includes a plurality of layers of contact components. For example, if 14 photovoltaic panel strings are connected to the rotary isolator switch, the rotary isolator switch needs to include at least 12 layers of contact components. The plurality of layers of contact components usually include connection mechanisms and moving contacts. Fixed contacts are connected through insertion by using the connection mechanisms and then stacked. When a drive mechanism is screwed, both rotating actions and kinetic energy of connecting and disconnecting the moving contact in each layer of the contact component are transferred by each layer of connection mechanism, to achieve effect of synchronous rotation. Because two adjacent connection mechanisms are inserted, there are factors such as clearance fit, a processing tolerance, or material deformation. In addition, the plurality of layers of contact components are sealed and installed in a housing of the rotary isolator switch. Therefore, rotation of the connection mechanism and the moving contact at each layer is invisible from the outside. After the drive mechanism is screwed, it cannot be ensured that the moving contact of each layer of contact component is in full contact with the fixed contact that matches the contact component. Especially, when there are a large quantity of contact component layers, a fit clearance or deformation between the foregoing connection mechanisms greatly accumulate. As a result, a moving contact at a farthest contact component suffers from significant kinetic energy insufficiency. This causes a case in which the moving contact at this layer is in poor contact with the fixed contact. Only when the moving contact at the farthest contact component is in contact with the fixed contact, it can be ensured that all contact components are in a connected state.

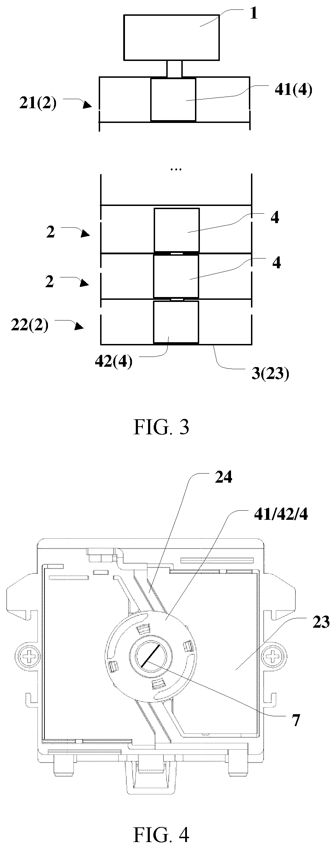

FIG. 2 is a diagram of a structure of a rotary isolator switch according to an embodiment of this application. FIG. 3 is a top view of a structure of a rotary isolator switch according to an embodiment of this application. FIG. 4 is a diagram of a structure of a switch unit according to an embodiment of this application. As shown in FIG. 2 to FIG. 4, to resolve the foregoing problem, an embodiment of this application provides a rotary isolator switch. The rotary isolator switch includes a drive mechanism 1 and a plurality of switch units 2. The drive mechanism 1 and the plurality of switch units 2 are sequentially arranged and installed along a first direction M. Each switch unit 2 includes one moving contact component 4. The moving contact components 4 in the plurality of switch units 2 are sequentially arranged along the first direction M. A switch unit 2 that is adjacent to the drive mechanism 1 is a first switch unit 21. Correspondingly, a moving contact component in the first switch unit 21 is a first moving contact component 41. A switch unit 2 that is farthest away from the drive mechanism 1 is a second switch unit 22. Correspondingly, a moving contact component 4 in the second switch unit 22 is a second moving contact component 42. The drive mechanism 1 is connected to the first moving contact component 41 and is configured to apply rotation force to the first moving contact component 41. Every two adjacent moving contact components 4 are connected through insertion along the first direction M, so that the drive mechanism 1 drives the moving contact components 4 in the plurality of switch units 2 to separately rotate around an axis A. A direction of the axis A is the same as the first direction M. The rotation force is sequentially transferred from the first moving contact component 41 that is closest to the drive mechanism 1 to the second moving contact component 42 that is farthest from the drive mechanism 1. To be specific, the drive mechanism 1 applies the rotation force to the first moving contact component 41. Then, a plurality of levels of moving contact components 4 sequentially transfer the rotation force. Finally, the rotation force is transferred to the second moving contact component 42 that is farthest from the drive mechanism 1.

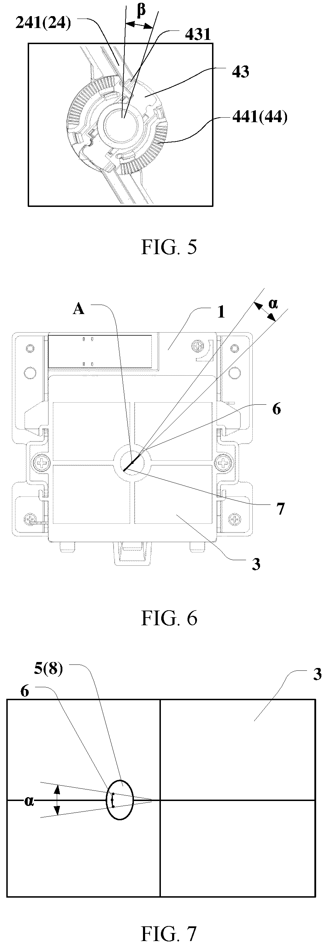

FIG. 5 is a partial diagram of a moving contact component and a fixed contact according to an embodiment of this application. With reference to FIG. 4 and FIG. 5, each switch unit 2 further includes a switch housing 23 and a fixed contact 24. The switch housing 23 has accommodating space. Both the fixed contact 24 and the moving contact component 4 are located in the accommodating space. The fixed contact 24 is securely installed on an inner wall of the switch housing 23, and the fixed contact 24 is located on a peripheral side of the moving contact component 4. The moving contact component 4 includes a moving contact 43. When the drive mechanism 1 drives the moving contact component 4 to counterclockwise rotate around the axis A, the moving contact 43 counterclockwise rotates around the axis A to be in contact with the fixed contact 24, so that the switch unit 2 is in a connected state. When the drive mechanism 1 drives the moving contact component 4 to clockwise rotate, the moving contact 43 clockwise rotates around the axis A to be separated from the fixed contact 24, so that the switch unit 2 is in a disconnected state.

The fixed contact 24 has a first surface 241, and the moving contact 43 includes a contact part 431. The moving contact 43 counterclockwise rotates relative to the fixed contact 24, so that the contact part 431 rotates relative to the first surface 241. When the moving contact 43 is in contact with the fixed contact 24 and then continues to rotate, the contact part 431 slides on the first surface 241. In this process, the switch unit 2 is always in the connected state. When the moving contact 43 continues to counterclockwise rotate to be separated from the fixed contact 24, the switch unit 2 is in the disconnected state. In other words, when the moving contact 43 counterclockwise rotates around the axis A, within a specific angle range (a first angle range, for example, the first angle range is 7°), the switch unit 2 is always in the connected state in a process from initial contact to full separation between the contact part 431 and the first surface 241. The contact part slides on the first surface, and a sliding range is large, so that the moving contact 43 still has some adjustment space when remaining in the connected state. This improves reliability of contact between the moving contact 43 and the fixed contact 24.

Under impact of a deviation caused by the clearance fit between the moving contact components 4, when the first moving contact component 41 is located at a connection position, the second moving contact component 42 farthest from the drive mechanism 1 may still be in a state in which the moving contact 43 and the fixed contact 24 are not in contact. Therefore, the drive mechanism 1 needs to continue to rotate by a specific angle, so that the moving contact 43 in the farthest second moving contact component 42 is in contact with the fixed contact 24, and moving contacts 43 in all the moving contact components 4 are in a contact state with the fixed contact 24.

With reference to FIG. 2 and FIG. 3, the switch housing 23 in the second switch unit 22 is a second switch housing. The second switch housing includes an isolation cover plate 3. The isolation cover plate 3 is located on a side that is of the second switch housing and that is away from the drive mechanism 1. In other words, the isolation cover plate 3 is located on a side that is of the second moving contact component 42 and that is away from the drive mechanism 1. An observation hole 5 and a reference mark 6 are provided on the isolation cover plate 3, so that a rotation angle of the second moving contact component 42 can be visualized. In this way, effect of observing a position of the second contact component 42 in real time is achieved, and a connection status of the rotary isolator switch can be further determined based on the position of the second contact component 42. When the isolation cover plate 3 is manufactured, a through hole, as the observation hole 5, may be provided on the isolation cover plate 3. The observation hole 5 is used for observation of an operation inside the rotary isolator switch from the outside of the rotary isolator switch. The second moving contact component 42 that is adjacent to the isolation cover plate 3 can be observed through the observation hole 5. Specifically, when the reference mark 6 is provided, the reference mark 6 may be located on a peripheral side of the observation hole 5. Vertical projections of the observation hole 5 and the second moving contact component 42 in the first direction M partially overlap, so that a rotation status of the second moving contact component 42 can be seen through the observation hole 5. A pointer 7 is disposed on a side that is of the second moving contact component 42 and that faces the isolation cover plate 3. The pointer 7 is perpendicular to the axis A, and an extension line of the pointer 7 passes through the axis A. The pointer 7 may be installed on a surface of the side that is of the second moving contact component 42 and that faces the isolation cover plate 3, or may be embedded on the side that is of the second moving contact component 42 and that faces the isolation cover plate 3. The second moving contact component 42 rotates around the axis A based on a manner in which the pointer 7 is aligned with the reference mark 6. When the drive mechanism 1 drives the first moving contact component 41 to rotate, the plurality of moving contact components 4 between the first moving contact component 41 and the second moving contact component 42 perform transferring layer by layer, so that the pointer 7 rotates with the second moving contact component 42 relative to the reference mark 6. When the pointer 7 points to the reference mark 6, each switch unit 2 is in the connected state. When the pointer 7 deviates from the reference mark 6, the switch unit 2 is in an under-connected or over-connected state. In the under-connected or over-connected state, the moving contact 43 is not in contact with the fixed contact 24.

The rotary isolator switch further includes a spacer 8 that covers the observation hole 5, and the spacer 8 is made of a transparent insulation material. The spacer 8 seals the isolation cover plate 3, thereby improving insulation performance of the isolation cover plate 3.

FIG. 6 is a front view of a rotary isolator switch according to an embodiment of this application. With reference to FIG. 5 and FIG. 6, in an embodiment, the reference mark 6 may be an annular sector. A center of the annular sector is located on the axis A. A central angle of the annular sector is α. When the contact part 431 is in contact with the first surface 241, a vertical projection of the pointer 7 in the first direction M points to any position in an area in which the annular sector is located. In this case, all the switch units 2 including the moving contact components 4 are in the connected state.

FIG. 7 is a diagram of an isolation cover plate according to an embodiment of this application. With reference to FIG. 5 and FIG. 7, in another embodiment, the reference mark 6 may also be an arc. The reference mark 6 is provided on the spacer 8. A central angle of the arc is α. A plurality of reference points may be set on the arc. When the contact part 431 is in contact with the first surface 241, a vertical projection of the pointer 7 in the first direction M points to any position in an area in which the arc is located. In this case, all the switch units 2 including the moving contact components 4 are in the connected state.

The central angle α of the reference mark is equal to a central angle β of an arc on which a sliding trajectory of the contact part 431 on the first surface 241 is located. The central angle β is a first angle range.

As shown in FIG. 2 or FIG. 6, the observation hole 5 may be in a plurality of shapes. In a specific embodiment, the observation hole 5 may be a circular hole that is located at a center of the isolation cover plate 3. In addition, the observation hole 5 and the moving contact component 4 are coaxially disposed.

In another specific embodiment, the observation hole 5 may be a ring-shaped hole (not shown in the figure) that is located at a center of the isolation cover plate 3. In addition, the observation hole 5 and the moving contact component 4 are coaxially disposed.

As shown in FIG. 7, in another specific embodiment, the observation hole 5 may be an elongated circular hole or an elliptical hole that may be located on a peripheral side of a center of the isolation cover plate 3, for example, located at a three o'clock or nine o'clock position of a longitudinal section of the isolation cover plate 3.

The observation hole is located at the position in some of the foregoing embodiments, so that an operation inside the rotary isolator switch can be clearly monitored through the observation hole 5. When the second moving contact component 42 is adjusted, the rotation trajectory of the pointer 7 can be seen from the observation hole 5 in any of the foregoing embodiments.

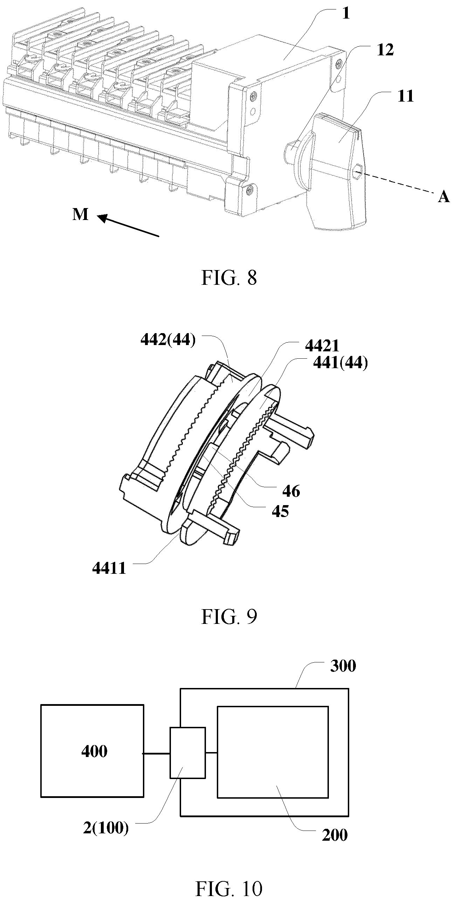

FIG. 8 is a diagram of a structure of a rotary isolator switch from another angle according to an embodiment of this application. As shown in FIG. 8, in an embodiment, the drive mechanism 1 includes an operation member 11 and a core shaft 12. An extension direction of the core shaft 12 is the first direction M. The operation member 11 is installed on one end of the core shaft 12, and the first moving contact component (not shown in the figure) is installed on the other end of the core shaft 12. By screwing the operation member 11, the core shaft 12 can be driven to rotate around the axis A, so that the plurality of moving contact components 4 also rotate around the axis A. The operation member 11 may be a knob, a handle, or another operation element.

In a specific embodiment, the moving contact component 4 includes a connection mechanism 44. The connection mechanism 44 includes a first housing 441 and a second housing 442. The first housing 441 and the second housing 442 are connected in a snap-fit manner to form an accommodating cavity. The moving contact 43 is fastened to the accommodating cavity. When the first housing 441 and the second housing 442 are manufactured, a mounting groove may be disposed on a surface of a side that is of the first housing 441 or the second housing 442 and that faces the accommodating cavity, and the moving contact 43 is installed in the mounting groove.

Connection mechanisms of every two adjacent moving contact components are connected through insertion to form a transmission shaft. The drive mechanism drives the transmission shaft to rotate, so that the moving contact rotates.

The following describes a specific structure of the connection mechanism 44.

In an embodiment, a surface of a side that is of the first housing 441 and that is away from the accommodating cavity is a second surface 4411. One slot 45 is disposed in a middle part of the second surface 4411. A surface that is of the second housing 442 and that is away from the accommodating cavity is a third surface 4421. One pin 46 is disposed in a middle part of the third surface 4421. The slot 45 and the pin 46 fit each other. Two adjacent connection mechanisms 44 are connected through insertion of the pin 46 into the slot 45.

A cross section of the foregoing pin may be a square, a triangle, a rectangle, or the like. The cross section uses a polygon, and all polygons have an angle, so that a ridge for transmission can be formed, thereby improving transmission effect of the pin.

FIG. 9 is a diagram of a structure of a connection between a first housing and a second housing of two adjacent connection mechanisms according to an embodiment of this application. As shown in FIG. 9, in another embodiment, a surface of a side that is of the first housing 441 and that is away from the accommodating cavity is a second surface 4411. Three pins 46 are disposed on the second surface 4411, and the pins 46 are located on a peripheral side of an axis A of the first housing 441. Correspondingly, a surface that is of the second housing 442 and that is away from the accommodating cavity is a third surface 4421. Three slots 45 fitting the pins 46 are disposed on the third surface 4421. The slots 45 are located on a peripheral side of an axis A of the second housing 442. The pins 46 are inserted into the three slots 45, thereby improving reliability of the connection between two adjacent connection mechanisms 44.

Still with reference to FIG. 4, the second housing 442 of the second moving contact component 42 is located between the first housing 441 and the isolation cover plate 3, and the pointer 7 is disposed on a surface of a side that is of the second housing 442 and that faces the isolation cover plate 3.

Still with reference to FIG. 2, in a specific embodiment, the rotary isolator switch includes 12 switch units 2, an annular sector is used as a reference mark 6, and a central angle α of the annular sector is 7°. When the drive mechanism 1 drives the moving contact component 4 to rotate around the axis A, and the pointer 7 points to an area of the annular sector, the moving contact 43 of the second contact component 42 is in contact with the fixed contact 24. In this case, all the switch units 2 in the rotary isolator switch are in the connected state.

FIG. 10 is a diagram of a structure of a power converter according to an embodiment of this application. As shown in FIG. 10, in another aspect, an embodiment of this application further provides a power converter. The power converter includes the rotary isolator switch 100 in any one of the foregoing embodiments, a power conversion circuit 200, and a housing 300. The rotary isolator switch 100 is securely installed on the housing 300. The power conversion circuit 200 is installed in the housing 300. The rotary isolator switch 100 is configured to connect to a direct current source 400 and the power conversion circuit 200. Specifically, the direct current source 400 may include a plurality of photovoltaic panel strings (not shown in the figure) that are connected in parallel, and each photovoltaic panel string is connected to a corresponding switch unit 2 in the rotary isolator switch 100. Alternatively, the direct current source 400 may include a plurality of battery clusters (not shown in the figure) that are connected in parallel, and each battery cluster is connected to a corresponding switch unit 2 in the rotary isolator switch 100. The direct current source 400 supplies power to the power converter when the rotary isolator switch 100 is turned on. The direct current source 400 stops supplying power to the power converter when the rotary isolator switch 100 is turned off. The photovoltaic panel string or the battery cluster is connected to the switch unit 2 in the rotary isolator switch. By using the observation hole 5 and the reference mark 6 of the foregoing rotary isolator switch 100, a rotation angle of the second moving contact component 42 can be visualized. In this way, effect of observing a position of the second contact component 42 in real time is achieved, and a connection status of the rotary isolator switch 100 can be further determined based on the position of the second contact component 42. An operating condition of the rotary isolator switch 100 can be observed in real time, and a user can adjust the driving component 2 in time based on an observation status, so that each switch unit 2 is in a connected state, thereby improving running reliability of the power converter.

It should be noted that, to implement the foregoing visualization, a relative position image of the pointer 7 and the reference mark 6 may be captured by using an image capturing device, and the image is observed after being output. Alternatively, the user directly performs observation through eyes.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include plural forms such as "one or more", unless otherwise specified in the context clearly.

Reference to "an embodiment", "a specific embodiment", or the like described in this specification means that one or more embodiments of this application include a specific feature, structure, or characteristic described with reference to the embodiment. The terms "include", "comprise", "have", and their variants all mean "include but are not limited to", unless otherwise specifically emphasized in another manner.

## Claims

1. A power converter, comprising a rotary isolator switch, a power conversion circuit, and a housing, wherein the rotary isolator switch is fastened to the housing, the power conversion circuit is located in the housing, the rotary isolator switch is configured to connect to a direct current source and the power conversion circuit, the direct current source supplies power to the power converter when the rotary isolator switch is turned on, and the direct current source stops supplying power to the power converter when the rotary isolator switch is turned off, and the direct current source comprises a photovoltaic module and an energy storage battery;
the rotary isolator switch comprises a drive mechanism and a plurality of switch units, the drive mechanism and the plurality of switch units are sequentially arranged and installed along a first direction, and each switch unit comprises a moving contact component;
a switch unit that is adjacent to the drive mechanism is a first switch unit, a moving contact component in the first switch unit is a first moving contact component, the drive mechanism is connected to the first moving contact component and is configured to apply rotation force to the first moving contact component, and two adjacent moving contact components are connected through insertion and are configured to sequentially transfer the rotation force, so that the drive mechanism drives the moving contact components in the plurality of switch units to separately rotate around an axis, wherein a direction of the axis is the same as the first direction; and
the switch unit that is farthest away from the drive mechanism is a second switch unit, the moving contact component in the second switch unit is a second moving contact component, the second switch unit further comprises an isolation cover plate, the isolation cover plate is located on a side that is of the second moving contact component and that is away from the drive mechanism, the isolation cover plate comprises an observation hole and a reference mark, vertical projections of the observation hole and the second moving contact component in the first direction partially overlap, and the observation hole is used for observation of a position of the second moving contact relative to the reference mark from the outside of the rotary isolator switch.

2. The power converter according to claim 1, wherein the reference mark is provided on a peripheral side of the observation hole.

3. The power converter according to claim 1, wherein the rotary isolator switch further comprises a spacer that covers the observation hole, and the spacer is made of a transparent insulation material.

4. The power converter according to claim 3, wherein the reference mark is provided on the spacer.

5. The power converter according to any one of claims 1 to 4, wherein the observation hole is located at a center of the isolation cover plate, and the observation hole and the second moving contact are coaxially disposed.

6. The power converter according to any one of claims 1 to 4, wherein a pointer is disposed on a side that is of the second moving contact component and that faces the isolation cover plate, and the pointer is perpendicular to the axis.

7. The power converter according to claim 6, wherein the second moving contact component comprises a connection mechanism and a moving contact, the connection mechanism comprises a first housing and a second housing, the first housing and the second housing are connected in a snap-fit manner to form an accommodating cavity, and the moving contact is fastened to the accommodating cavity.

8. The power converter according to claim 7, wherein the second housing is located between the first housing and the isolation cover plate, the pointer is disposed on a surface of a side that is of the second housing and that faces the isolation cover plate, and an extension line of the pointer passes through the axis.

9. The power converter according to claim 8, wherein the switch unit further comprises a fixed contact, the fixed contact is installed on a peripheral side of the moving contact component, and the moving contact component comprises a moving contact; and when the drive mechanism drives the moving contact component to rotate, the moving contact in the moving contact component and the fixed contact are in contact with each other or are separated from each other.

10. The power converter according to claim 9, wherein the fixed contact comprises a first surface, the moving contact comprises a contact part, and when the contact part and the first surface are in contact with each other, the switch unit is in a connected state.

11. The power converter according to claim 10, wherein the reference mark is an annular sector, a center of the annular sector is located on the axis, and when the contact part of the second moving contact component is in contact with the first surface, a vertical projection of the pointer in the first direction points to the annular sector.

12. The power converter according to claim 11, wherein when the second moving contact component rotates around the axis within a first angle range, the contact part of the second moving contact component keeps in contact with the first surface.

13. The power converter according to claim 12, wherein the first angle range is equal to a central angle of the annular sector.

14. The power converter according to claim 13, wherein the central angle of the annular sector is 7°.
